(19) Europäisches Patentamt / European Patent Office / Office européen des brevets

(11) **EP 2 074 356 B1**

(12) **EUROPEAN PATENT SPECIFICATION**

(45) Date of publication and mention
of the grant of the patent:
**09.03.2016 Bulletin 2016/10**

(21) Application number: **06821728.0**

(22) Date of filing: **09.10.2006**

(51) Int Cl.:
**H01L 31/052** (2006.01)    **F24J 2/20** (2006.01)

(86) International application number:
**PCT/IT2006/000712**

(87) International publication number:
**WO 2008/044250 (17.04.2008 Gazette 2008/16)**

(54) **PROCESS FOR MANUFACTURING COMBINED SOLAR PANELS OF PHOTOVOLTAIC AND THERMAL TYPE AND RELATED SOLAR PANEL**

VERFAHREN ZUR HERSTELLUNG VON KOMBINIERTEN SOLARPLATTEN DER PHOTOVOLTAIK-UND THERMALART UND VERWANDTE SOLARPLATTE

PROCÉDÉ DE FABRICATION DE PANNEAUX SOLAIRES DU TYPE PHOTOVOLTAÏQUE ET THERMIQUE COMBINÉS ET PANNEAU SOLAIRE CORRESPONDANT

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**01.07.2009 Bulletin 2009/27**

(73) Proprietor: **S.I.E.M. S.r.l.**
**73100 Lecce (IT)**

(72) Inventor: **AGUGLIA, Jorge, Miguel**
**I-73100 Lecce (IT)**

(74) Representative: **Robba, Pierpaolo**
**Interpatent S.R.L.**
**Via Caboto 35**
**10129 Torino (IT)**

(56) References cited:
**WO-A-99/10934        DE-A1- 10 064 164**
**DE-U1- 9 108 635      DE-U1- 20 215 462**
**US-A- 4 587 376       US-A1- 2004 025 931**

## Description

## Technical Field

The present invention generally refers to a process for manufacturing combined solar panels of photovoltaic and thermal type capable of converting the solar energy into both electric and thermal energy with high efficiency. The present invention further generally refers to a solar panel manufactured through such a process.

More particularly, the present invention refers to a process for manufacturing solar panels comprising, in combination, at least one photovoltaic panel and one heat-exchanging thermal panel (heat exchanger).

## Background Art

There are known solar panels of photovoltaic and thermal type(combined solar panels) adapted to convert solar energy into electric and thermal energy.

For example, from the publication US 2004/0025931 in the name of the Applicant, it is known a combined solar panel adapted to simultaneously generate both electric and thermal energy. A known solar panel includes a panel or heat exchanger containing a fluid, and a photovoltaic panel comprising a plurality of photovoltaic cells and a glass sheet.

More particularly a known thermal exchanger includes a plate made of a heat-conducting material (plate) glued to a first face of the photovoltaic cells (cells), with a second face of the cells - to be exposed to the solar energy - which is protected by the glass sheet (sheet) which too is glued to the cells.

The process for manufacturing the known combined solar panels provides that, in order to glue the sheet and the plate to the opposite faces of the cells, a thin transparent layer of ethyl vinyl acetate (Ethyl Vinyl Acetate or EVA) is interposed between the sheet and the cells and between the cells and the plate. The EVA used in the known process contains additives for delaying its yellowing (which is caused by the exposure to the ultraviolet rays during the operating life of the solar panel) and have the purpose to prevent a direct contact between the cells and the glass or plate, to eliminate the interstices that would otherwise be formed because of a not perfectly smooth surface of the cells, and to electrically insulate the active part of the photovoltaic panel.

The cells of the photovoltaic panel are generally glued to the sheet and to the plate through a vacuum curing (polymerisation) process carried out in an apparatus known as "laminator", comprising an upper chamber and a lower chamber horizontally divided by an elastic membrane. The lower chamber of the laminator contains an electric plate capable to maintain an inner temperature rather uniform and constant, with oscillations within $\pm$ 20°C.

A typical laminating cycle begins by placing the sandwich or module formed by glass, EVA, photovoltaic cells, EVA and plate, inside the lower chamber, making vacuum in both chambers and bringing the laminator to a temperature of about 100°C so as to remove air stagnation (bubbles) from the sandwich.

The vacuum is then removed from the upper chamber, so that the membrane separating the two chambers uniformly compresses the module thus favouring the adhesion of the EVA to the cells, to the front glass and the plate, and the laminator is brought to a temperature of about 150°C, that allows the polymerisation of the EVA. This step can last from 10 to 20 minutes.

Finally the temperature is lowered to 100°C and air is slowly admitted.

It is stressed that the parameters of the lamination cycle are always selected as a result of a trade-off among the specifications supplied by the EVA manufacturers, the specific experimentation of the module producers, and an optimisation of the process times with the aim to increase the production per hour. In fact, on the one hand, in order to evaluate the lamination quality it is often used the degree of EVA polymerisation, chemically determined through its insolubility (by weighing the starting amount of the polymer and the final dry residue after the thermal treatment), but on the other hand the finished product has to be obtained in the shortest time as possible and with a cost of the electric energy which is optimised in respect of its quality.

Although the lamination process for manufacturing the modules is not complex and the lamination discard rate is pretty low (<2%), the combined solar panels and particularly the photovoltaic panels are not faultless, even because of the additional operations that are often manually accomplished (such as cell alignment, welding of the contacts between the cells, welding of the termination strings, etc.).

The CEI EN 61215 (CEI 82-8) regulation lists the defects that can be recognized in a photovoltaic panel through a visual inspection (test 10.1) and through other inspections, but does not establish a merit classification which on the other hand would be useful for an acceptance test of a supply.

A typical defect listed in the above regulation as a defect that can be recognized through visual inspection (visually), it is the breakage of parts of one or more cells, generally caused by an excessive pressure during the lamination or by an improper handling of the cells in the assembly step.

Besides the defects that can be visually recognized, there are defects that cannot be visually detected and are surely more insidious.

Of course there are methods adapted to verify existence of defects before installing the solar panel, but since as a general rule they are time-consuming tests and some times invasive and requiring expensive equipments, the detection of these defects is generally committed to the guarantee supplied by the factory quality control on samples (by using anyway the reference regulations for the number of the samples in order that the tests are statistically meaningful).

Among the most common defects that cannot be visually detected there are the so-called "hot spot."

The hot spots are locations of the solar panel (panel) at which, in the operating panels, a temperature is detected that is higher by some degrees than that of the remainder of the panel, which temperature excess is caused by an high electric resistance, usually caused by defective welding. The hot spots can be detected, for example, through IR imaging (infrared analysis) of the panel under working conditions. Defective welding also causes electric disconnection of panel portions, possibly after years of regular exposition and working.

Among the defects that cannot be visually detected, one of the most common is the EVA yellowing after several years of operating life. Early optical degradation of the EVA by altering the colour towards a characteristic yellow-brown colour decreases the transmittance value. The main cause of the yellowing is a low polymerisation degree (<70%) and an improper stocking of the EVA before the lamination. Generally this defect doesn't determine appreciable reductions of the solar panel performance per se.

Rather a more serious drawback arises from the associated production of acetic acid released by the EVA decomposition in contact with the cells, that can induce the corrosion of electrically conductive parts, such as electric contacts, etc.

Still more serious are the panel delaminations in use because of the ungluing among the different layers of the panel. Delamination is generally due to a poor cleaning in the assembly step of the panel or to a low degree of EVA polymerisation (<70%). During type tests (i.e. tests on a panel sample taken from the production line), delamination is checked through normalised cycles, for example according to CEI EN 61215, in a thermal chamber.

A further relevant state of the art document is represented by WO 99/10934.

Resuming, the Applicant discovered that the known process for manufacturing composite solar panels brings about a number of problems the solution of which would allow a reduction of the defectiveness of the panels, both those visible and those that are not visible.

More particularly, the Applicant discovered that, in the known manufacturing process, the cell welding process and the lamination cycle are particularly critical and subjected to introduce defects in the composite solar panels.

## Disclosure of the Invention

It is an object of the present invention to provide a process for manufacturing a combined solar panel that is devoid of the above cited defectiveness problems, both visible and not visible ones.

An additional objects of the present invention is to provide a solar panel of the photovoltaic and thermal type having a high overall efficiency.

In accordance with the present invention, these objects are accomplished through a process for manufacturing solar panels of the photovoltaic and thermal type and through a high efficiency solar panel as claimed in the attached claims.

The claims constitute integral part of the technical teaching hereby disclosed in respect of the invention.

In accordance with a preferred embodiment, the process according to the present invention for manufacturing combined solar panels in which there is provided the presence of a thermal panel and a photovoltaic panel equipped with photovoltaic cells and a sheet that is transparent to the solar energy, provides that the cells of the photovoltaic panel are fixed to the thermal panel and to the transparent sheet thanks to a discrete number of glue spots and a resin.

In accordance with a further characteristic of the present invention, the manufacturing process provides that the resin is introduced into the panel during its construction by applying a progressive vacuum to the vertically positioned panel being manufactured.

In accordance with another characteristic of the present invention, the cells of the photovoltaic panel have contacts that are associated to rheophores having an increased cross-section in comparison to that of the contacts so as to optimise the electric efficiency of the photovoltaic panel by reducing the voltage drops.

## Brief Description of Drawings

The above and other characteristics of the present invention will result clear from the following description of preferred embodiments, given only with exemplary and not limiting purposes, with the aid of the attached figures, in which components indicated by a same or similar numerical reference relate to components having the same or similar functionality and construction, and in which:

    Fig. 1 is a perspective and cross-sectioned view of a combined solar panel according to the invention;
    Fig. 2 and Fig. 3 schematically illustrate a first step of a process according to the invention;
    Fig. 4a and Fig. 4b schematically illustrate a second step of a process according to the invention;
    Fig. 5a, Fig. 5b and Fig. 6 schematically illustrate a third step of a process according to the invention.

## Best mode for Carrying Out the Invention

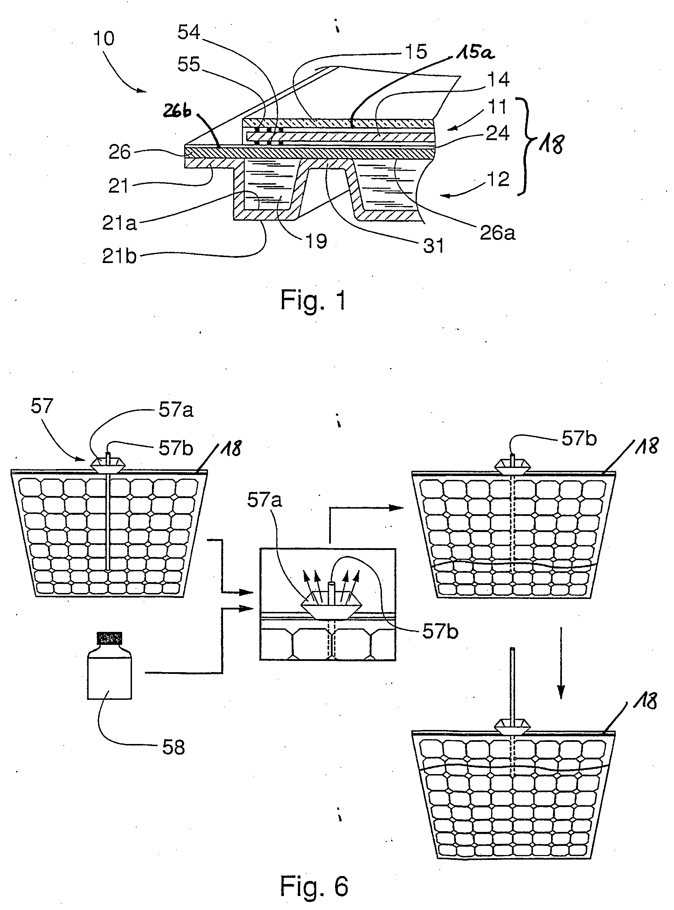

With reference to Fig. 1 a process for manufacturing a combined solar panel (solar panel) 10 comprising a photovoltaic panel 11 and a thermal panel (thermal exchanger) 12 combined together provides, in a first step, the construction of the thermal exchanger 12.

More particularly, the thermal exchanger 12 is realized as follows:

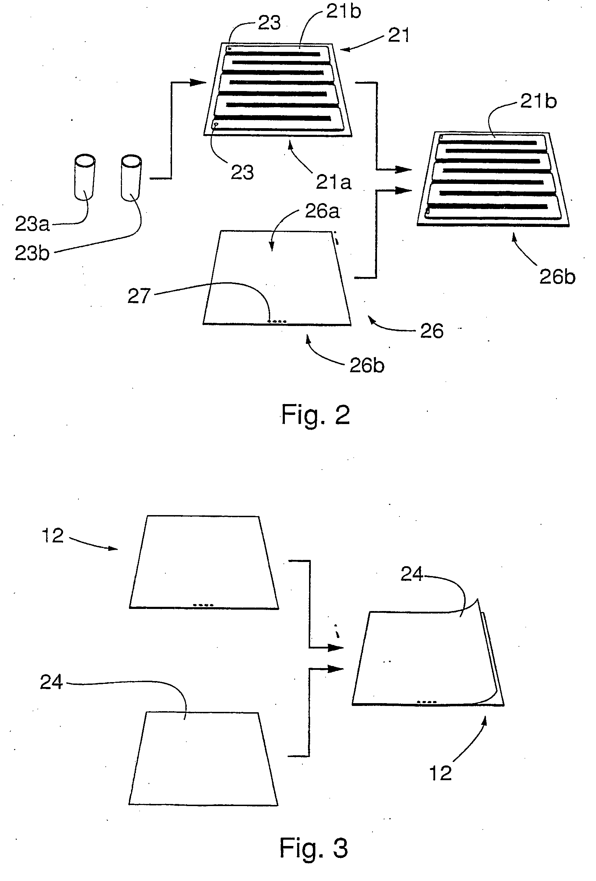

-     a first sheet (lower sheet) 21 (Fig. 1, Fig. 2) preferably of a metal, for example stainless steel, copper, aluminium, zinc, thermally conducting alloys, etc is press-folded so as to create on a first face 21 relieves 31 adapted to create, in known manner, a preferential path for a heat-carrying fluid (fluid) 19, for example water;

- preferably in correspondence of the path ends, there are formed respective holes 23 in which pipe sections 23a and 23b respectively (Fig. 1 and Fig. 2) are fitted and welded for providing an inlet and an outlet to the fluid;

- a second sheet (upper sheet) 26, preferably one flat sheet, substantially equivalent to the first sheet 21 in respect of the surface and the material, has a first face or inner face 26a that is welded to the relieves 31 of the first face 21a of the first sheet 21, so as to form the heat exchanger 12, i.e. a closed hull adapted to contain the fluid. The so formed heat exchanger (the hull) 12 has a first outer face 26b corresponding to the second face of the second sheet 26, and a second outer face 21b corresponding to the second face of the first sheet 21. Preferably the second sheet 26 is welded to the first sheet 21 in a known manner, by overlapping and pressing the relieves 31 on the inner face 26a of the second sheet 26. This type of welding, preferably carried out without filler material and exploiting the known Joule effect caused by an electric current passing through the materials to be welded, is advantageous since it provides a high sealing level to the pressure of the fluid inside the heat exchanger 12, when the temperature of the fluid changes;

- preferably, as a complementary step, a layer of a thermally insulating material of known type 24, is applied over the second outer face (lower face) 21b of the hull 12 and a thin layer or film 24 (Fig. 2, Fig. 3) of an electrically insulating material, for example mylar or an equivalent material of known type, is placed in contact with the first outer face (upper face) 26b of the hull 12. Such complementary step prepares the heat exchanger to be coupled with the photovoltaic panel 11 to realize the solar panel 10.

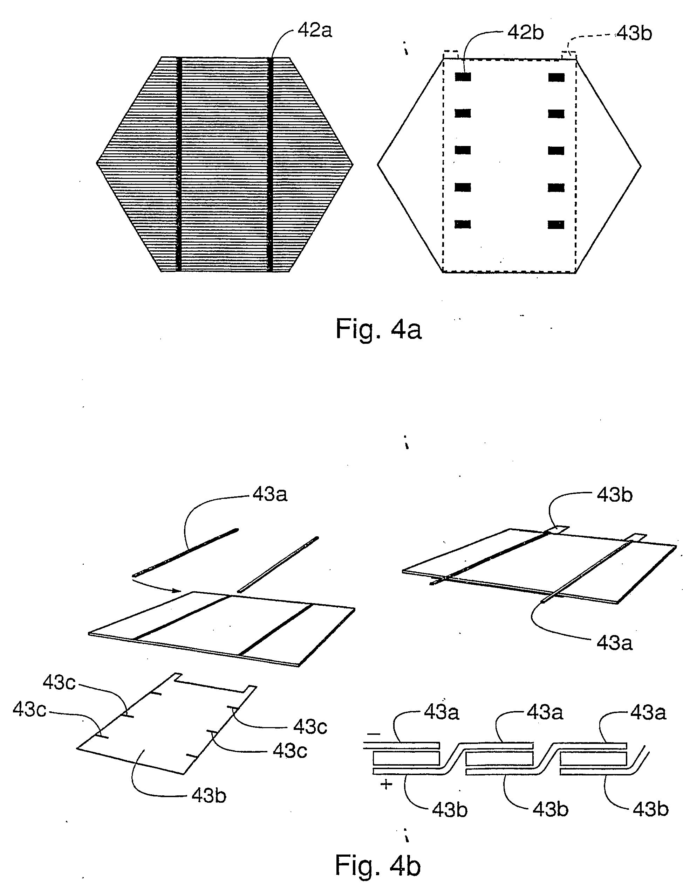

In a second step there is foreseen to make strings 40 (Fig. 4a, Fig. 4b) of photovoltaic cells (cells) 41 with a length determined as a function of the panel size (10 - Fig. 1); this second step is a pre-arrangement to the construction of the photovoltaic panel 11 to be combined with the heat exchanger 12.
More particularly, the strings 40 (Fig. 4a, Fig. 4b) are realized as follows:

- a plurality of cells 41, in a number predetermined as a function of the size of the panel 10, are aligned and welded together, e.g. in series. The cells 41, of a known type, are for example cells of crystalline silicon of circular or octagonal shape, each having on opposite faces, contacts of opposite polarity, respectively first contacts 42a and second contacts 42b. In the preferred embodiment, the contacts of each face, 42a and 42b respectively, are associated to respective rheophores, first 43a and second rheophores 43b, so that the first rheophores 43a of a first cell 41 are connected, for example by welding, to the second rheophores 43b of a second cell 41, and the first rheophores 43a of the second cell 41 are connected to the second rheophores of a third cell 41, and so on. As can be easily understood by the skilled of the art, such arrangement amounts to a series connection of the cells 41.

Preferably, the welding is carried out, for example, through a front/rear welder of a known type..
Still more preferably the cell connecting rheophores, 43a and 43b respectively, are made with a larger thickness than usual. For example the first rheophores 43a are made by welding to the contacts 42a, generally having a rectangular cross-section of about 2 x 0,1-0,2 mm, rectangular cross-section leads of 2,5-3,0 x 0,3 mm, whereas the second rheophores 43b are made by welding to the contacts 42b a suitably-sized thin metal sheet preferably comprising one or more notches or folds 43c, transversally extending with respect to the welding direction, adapted to prevent the cell from being subjected to mechanical stress during the welding.
The so formed rheophores allow to reduce the voltage drop caused by the connections between a cell and another thus optimising the photovoltaic panel efficiency.
As a matter of fact, the electric resistance of an electric connection is given by the known relationship

$$R = \rho \, L/S$$

where

p = material resistivity
L = conductor length
S = conductor cross-section

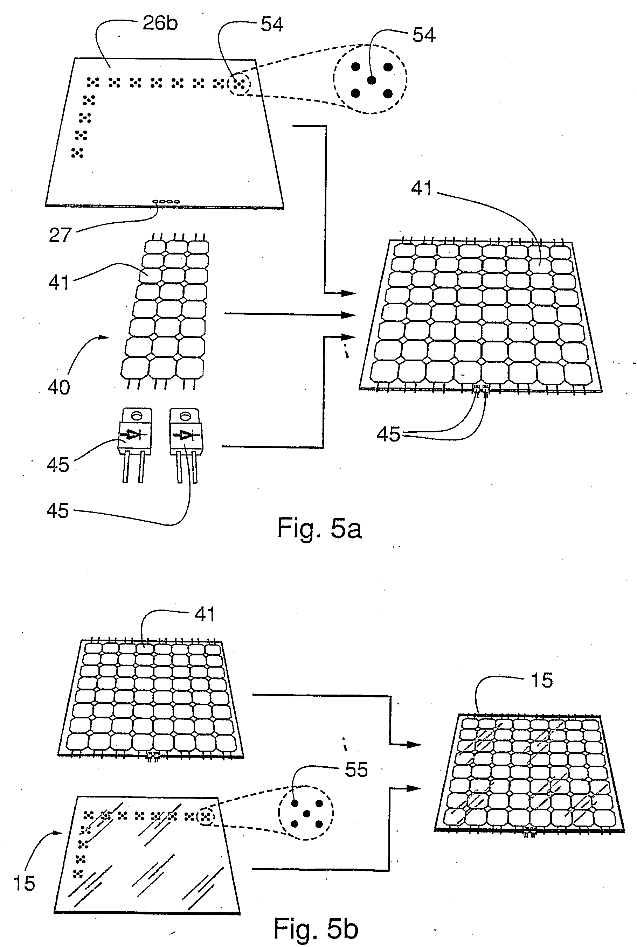

Obviously, an increase of the current (power) generated by the cells brings about an increase of the voltage drop on the connections (ribbons) between the cells. A way to reduce these voltage drops is to increase the quantity S i.e. to increase the thickness of the connections between the cells. The above described arrangement increases the rheophores's thickness, thus reducing the voltage drop caused by the electric connections and optimises after all the efficiency of the photovoltaic panel.
In a third step of the process it is provided that the photovoltaic panel 11 is directly made and combined with the heat exchanger 12 (Fig. 1, Fig. 5a, Fig. 5b, Fig. 6), which panel, in accordance with the present embodiment, includes at least a photosensitive layer 14 comprising one or more strings 40 of cells 41 and a transparent sheet (sheet) 15, for example a glass sheet. The photovoltaic panel 11 is built as follows:

- over the film (insulating layer) 24 a number of glue spots 54, for example of silicone with a UV catalyst or polyurethane are applied according to a predetermined pattern. In the preferred embodiment, the glue spots 54 are positioned by means of a numerical control machine or a robot, and they are arranged in such a way that groups of at least five glue spots (spots) 54, for example four peripheral spots and a central one, correspond to the location at which each cell 41 of a string 40 has to be positioned. The glue spots 54 positioned in this way realize a bed of glue spots or spacers 54 - of an insulating material in the illustrated example - over which the strings 40 formed in the second step will rest;

- the spacers 54 are cured or catalysed, e.g. by exposing them to ultraviolet radiations (UV);

- in a known manner the strings 40 are located over the spacers 54 so as to form the photosensitive layer 14 and are connected in series to realize (preferably) two series circuits the opposite polarity ends of which are connected in a known manner to protection diodes 45. Preferably, the diodes 45 are secured to suitably located holes 27 of the upper sheet 26 of the heat exchanger 12;

- a further number of glue spots 55, for example of silicone with UV catalyst or polyurethane, are applied over a first face 15a of the plate 15 at predetermined positions. In the preferred embodiment the glue spots 55 are positioned by means of a numerical control machine or a robot, and they are arranged in such a way that groups of at least five glue spots (spots) 55, for example four peripheral spots and a central one, corresponds to the location of each cell 41 of a string 40. Also in this case the glue spots 55 realize a bed of glue spots or spacers 55 adapted to keep the plate 15 spaced from the cells 41;

- the spacers 55 are catalysed, e.g. by exposing them to ultraviolet radiations (UV);

- the first face 15a of the plate 15 is positioned over the photosensitive layer 14 so that the spacers 55 rest over the photosensitive layer 14 and there is no direct contact between the plate 15 and the photosensitive layer 14;

- the so stacked heat exchanger 12, insulating layer 24 and photovoltaic panel 11 are sealed along their sides, along four sides in the example, so as to form a module or sandwich 18 that is compact and easy to handle. The sealing is preferably accomplished with polyurethane. In the preferred embodiment, it is provided that during the sealing on the sides, a limited zone or area along one side, preferably a barycentric area, is not sealed and comprises two devices such as, for example, a sucking pipe 57a and a cannula 57b. As will be described in more details in the following, these two devices, 57a and 57b respectively, are adapted to allow for both the application of a controlled vacuum to the module 18 and the insertion of a filling resin 58 into the zones between the insulating layer 24 and the photosensitive layer 14 and between the plate 15 and the photosensitive layer 14 in which the beds of spacers are present;

- the partially sealed module 18 is fixed to a work-table (not shown) that can be rotated so as to assume an inclination comprised at least between 0° and 90°;

- the table is rotated so that the module assumes a substantially vertical starting position in which the unsealed limited area 57 is in an upper position;

- through the suction pipe 57a, a given initial vacuum level is applied to the module 18, for example - 0,1 bar and through the cannula 57b the highly transparent resin starts to be introduced into the module 18. According to a preferred embodiment, the resin 58, e.g. a marketed catalysed resin, is inserted while at the same time the vacuum is increased proportionally to the increasing level of the resin in the module; the cannula 57 is progressively extracted from the module, leaving however an end bathed by the resin until the cannula is completely removed at the end of the filling process. The initial vacuum is advantageous for expelling possible air bubbles from the module, whereas the vacuum increase during the introduction of the resin 58 advantageously balance the pressure exerted by the resin on the module components and prevents possible breakages of such components;

- once the resin introduction has been completed, the work-table is rotated so that the module 18 substantially assumes a horizontal position (final position). According to a preferred embodiment the vacuum is progressively decreased during such rotation, for example in a manner proportional to the angular change, from a maximum value to a minimum value, such as for example from 0.5 bars to 0.05 bars. At the end of the rotation the module will show the minimum inclination, such as to avoid the resin spillage, and at the same time even the pressure applied by the resin onto the module components will be minimum;

- the vacuum is completely removed, the suction pipe 57a is removed and the sealing is completed. At the end of the sealing, preferably, the module is maintained in a controlled environment (in respect of temperature, moisture, etc.) for a given time such as for example one day, to allow a good cross-linking of the resin. With this step the manufacturing of the photovoltaic panel 11 is completed, as well as that of the solar panel 10 that it is ready to be installed and used.

According to a preferred embodiment, starting from the surface to be exposed to the solar energy, a solar panel 10 manufactured through the disclosed process comprises:

- a plate 15, for example a plate of glass or of a plastic material of known type;

- a first bed of spacers 55, adapted to electrically insulate the plate 15 and to maintain it at a predetermined distance from the photosensitive layer 14;

- a second bed of spacers 54, adapted to electrically insulate the photosensitive layer 14 and to maintain it at a predetermined distance from the insulating layer 24 covering the upper face 26b of the heat exchanger 12;

- the resin 58, adapted to embed the photosensitive layer 14 and to electrically insulate it from the plate 15 and from the heat exchanger 12;

- the insulating layer 24;

- the heat exchanger 12 comprising the upper sheet 26, the heat-carrying fluid 19 adapted to transport the collected solar energy, the lower sheet 21;

- the layer of thermally insulating material 24.

Preferably the plate 15 has a high mechanical resistance, high transparency, high thermal transmittance U (W/m2*K), high planarity, high hardness, is capable to protect the lower elements from water infiltrations and from chemically reacting pollutants, it is selected so as to not pollute the substrate through migration processes, it is resistant to atmospheric abrasion and erosion, it is chemically and geometrically stable at high temperatures. The plate can be for example a toughened glass plate of known type. Preferably the spacers 54 and 55 have high resistance to ageing and light, high resistance to the large temperature changes, good adhesion to the substrata, elasticity, a wide range of operating temperatures, good impermeability to gases, good electric resistance, elevated chemical inertia towards the photovoltaic cells and with the cell embedding material, high optical transparency. For example the spacers are made of silicone.

The photosensitive layer 14 is preferably formed by elementary photovoltaic cells of crystalline silicon, for example cells with a power of 2.1 W and size of 125 x 125 mm from SHARP or from ENI-EUROSOLARE companies. Of course the manufacturing process and the panel can be used for different kinds of cells, such as for example thin film cells, gallium arsenide cells, etc.

The resin or the embedding/blocking material of the cells 58 has preferably a high transparency, high binding power, short curing times and it is not thermosetting, has a high thermal dispersion, low viscosity, high resistance to ageing and to light, including the ultraviolet radiation, high resistance to the large temperature changes, an extended range of operating temperatures ($-30°C \leq T \leq 150°C$) uniformity and continuity in the distribution of the mechanical stresses/tensions, high plasticity, it is chemically inert and is a good dielectric.

The resin can be for example a commercial resin of the CE9500 type cured with CE9500 cat. or of the CE100-7 A.E. type cured with CE100-7 A.E. sold by CAFARELLI RESINS company, or a resin of the NT620 type cured with NT620 cat. of the NEW TECH company.

Of course, as will be evident to the skilled of the art, the resin can also be of other types without departing from the scopes of the invention as described and claimed.

Preferably the heat exchanger 12 is a thermal machine in which power is transferred to a fluid through a solid surface. The laws governing such power transfer are irradiation, convection, forced convection and conduction. The heat exchanger includes sheets, preferably metal sheets, having a large thermal conductivity k, a low "fouling factor" F = (m2*K/W) both on the side where the cooling fluid flows, and on the outer side of the exchanger (panel/external environment border), large resistance to chemical oxidation/reduction processes, and is adapted not to contaminate the cells through ion migration processes, good weldability, high deformability and resistance to mechanical stresses.

Preferably the heat carrying fluid 19 has a large cooling capability, a low kinematic viscosity (m2/s), and is not polluting.

Preferably the layer of insulating material 24 is adapted to provide a large thermal insulation, very good protection against water infiltrations and against polluting agents that are chemically reactive, is resistant to atmospheric abrasion and erosion, has a stable insulating power and is geometrically stable in the time. The insulating material is, for example, polyurethane foam or plastic material.

In accordance with a preferred embodiment of the above disclosed manufacturing process, the glue spots, 54 and 55, are applied onto the insulating layer 24 and the plate 15, respectively. According to other embodiments the glue spots can of course be applied, for example by a numerical control machine, onto opposite faces of the strings 40 of cells 41 without departing from the scope of the invention as disclosed and claimed.

According to a preferred embodiment, the manufacturing process and the panel provide for the presence of the insulating layer 24, but of course, as can be easily understood by the skilled of the art, the presence of this layer is not compulsory since both the bed of the spacers 54 and the resin 58 are adapted to electrically insulate the upper face 26b of the heat exchanger 12 from the photosensitive layer 14.

Since the solar panel manufactured as disclosed does not require lamination steps, it is not affected by the drawbacks deriving from such steps. More particularly, the lack of lamination steps and the provision of steps for introducing properly selected resins into the module, ensures a high quality and a lack of defects in the short and medium term.

Moreover, the use of connections between the cells using conductors of increased thickness optimises the efficiency of the cells.

Several obvious changes are possible to the above description in respect of size, shapes, materials, components, circuit elements and connections, as well as in respect of the circuitry details, of the illustrated construction and of the manufacturing process without departing from the invention as defined in the attached claims.

**Claims**

1. A process for manufacturing combined solar panels (10) of the photovoltaic and thermal type, comprising the steps of

   - building a thermal panel (12) having at least one flat face (26b) ;
   - building a photovoltaic panel (11) adapted to be combined with said thermal panel (12) through said flat face (26b) and comprising at least one string (40) of photovoltaic cells (41) and a transparent sheet (15);

   **characterized in that** the step of building the photovoltaic panel (11) comprises the steps of

   - applying a number of glue spots (54, 55) between said flat face (26b) and said at least one string (40) and between said at least one string (40) and said sheet (15) respectively, so as to form a combined module (18) with a plurality of peripheral sides;
   - introducing a transparent resin (58) between said flat face (26b) and said at least one string (40) and between said at least one string (40) and said sheet (15).

2. A process for manufacturing combined solar panels (10) according to claim 1 **characterized in that** the step of applying the glue spots (54, 55) comprises

   - applying a first set of glue spots (54) onto said flat face (26b) or onto a first face of said at least one string (40);
   - applying a second set of glue spots (54) onto said sheet (15) or onto a second face of said at least one string (40).

3. A process for manufacturing combined solar panels (10) according to claim 1 or 2, **characterized in that** said step of introducing the resin (58) comprises

   - partially sealing said module (18) leaving at least one side of said plurality of sides with one unsealed zone (57);
   - positioning the module (18) in a substantially vertical position so that said at least one zone (57) is located in an upper position;
   - applying to said module (18), through said zone (57), a given level of vacuum; and
   - introducing said resin (58) into said module (18) progressively increasing the level of the applied vacuum.

4. A process for manufacturing combined solar panels (10) according to claim 3, **characterized in that** the step of introducing the resin (58) comprises the further steps of

   - positioning the module (18) in a substantially horizontal position;
   - completely sealing said module (18).

5. A process for manufacturing combined solar panels (10) according to any one of claims 1 to 4, **characterized in that** the step of manufacturing the thermal panel (12) comprises the step of

   - applying in contact of said at least one flat face (26b) at least one layer (24) of electrically insulating material.

6. A process for manufacturing combined solar panels (10) according to any one of claims 1 to 5, **characterized in that** the step of manufacturing the photovoltaic panel (11) also comprises the construction of at least one string (40) of cells (41), said cells comprising first contacts (42a) and second contacts (42b) of opposite polarity and having a predetermined cross-section size;
   the construction of said string comprising the steps of

   - applying to said first contacts (42a) first rheophores (43a) with a cross-section size that is larger than the size of the cross-section of said first contacts (42a);
   - applying to said second contacts (42b) second rheophores (43b) with a cross-section size that is larger than the size of the cross-section of said second contacts (42b);
   - connecting the first rheophores (43a) of a first cell (41) to the second rheophores (43b) of a second cell (41) and repeat the connecting operation for the cells present in the string so as to realize a series connection of the cells (41).

7. A combined solar panel (10) comprising

   - a thermal panel (12) having at least one flat face (26b);
   - a photovoltaic panel (11) adapted to be combined with said thermal panel (12) through said flat face (26b) and comprising at least one string (40) including a plurality of photovoltaic cells (41) connected to one another and a transparent sheet (15) ;
   - a number of glue spots (54, 55) between said flat face (26b) and said at least one string (40) and between said at least one string (40) and said sheet (15) respectively; **characterized by** comprising

    - a transparent resin (58) between said flat face (26b) and said at least one string (40) and between said at least one string (40) and said sheet (15).

**8.** A solar panel (10) according to claim 7 **characterized in that** said glue spots are made of a material or a combination of materials selected from the group of:

    - silicone with UV catalyst;
    - polyurethane.

**9.** A solar panel (10) according to claim 7 or 8, **characterized in that** said resin is mode of a material or a combination of materials selected from the group of:

    - cured resin type CE9500;
    - cured resin type CE100-7 A.E.;
    - cured resin type NT620.

**10.** A solar panel (10) according to any one of claims 7 to 9, **characterized in that** it comprises at least a layer (24) of electrically insulating material in contact with said at least one flat face (26b) of said thermal panel (12).

**11.** A solar panel (10) according to any one of claims 7 to 10, **characterized in that** said cells (41) of said plurality of cells include first contacts (42a) and second contacts (42b) of opposite polarity having a cross-section of predetermined size and **in that** to said first contacts (42a) first rheophores (43a) are fixed having a cross-section larger than the size of the cross-section of said first contacts (42a), and that to said second contacts (42b) second rheophores (43b) are fixed having a cross-section larger than the size of the cross-section of said second contacts (42b).

**12.** A solar panel (10) according to claim 11 **characterized in that** said second rheophores are realized through a thin sheet metal welded to said second contacts (42b).

**Patentansprüche**

**1.** Verfahren zur Herstellung von kombinierten Solarplatten (10) der Fotovoltaik- und Thermalart, das folgende Verfahrensschritte umfasst:

    - Erstellung einer thermischen Platte (12) mit mindestens einer ebenen Fläche (26b);

    - Erstellung einer zur Kombination mit der ebenen Fläche (26b) der thermischen Platte (12) geeigneten fotovoltaischen Platte (11), die mindestens eine Reihe (40) fotovoltaischer Zellen (41) sowie eine transparente Schicht (15) aufweist;

**dadurch gekennzeichnet, dass** die Operation der Erstellung des fotovoltaischen Platte (11) folgende Schritte umfasst:

    - Aufbringung einer Anzahl von Klebepunkten (54, 55) zwischen der ebenen Fläche (26b) und der mindestens einen Reihe (40) beziehungsweise zwischen der mindestens einen Reihe (40) und der Schicht (15), um ein kombiniertes Modul (18) mit einer Vielzahl von peripheren Flächen zu schaffen;
    - Einbringung eines transparenten Harzes (58) zwischen die ebene Fläche (26b) und der mindestens einen Reihe (40) sowie zwischen der mindestens einen Reihe (40) und der Schicht (15).

**2.** Verfahren zur Herstellung kombinierter Solarplatten (10) nach Anspruch 1, **dadurch gekennzeichnet, dass** das Aufbringen der Klebepunkte (54, 55) Folgendes umfasst:

    - Auftrag eines ersten Satzes von Klebepunkten (54) auf die ebene Fläche (26b) oder auf eine erste Fläche der mindestens einen Reihe (40);
    - Auftrag eines zweiten Satzes von Klebepunkten (54) auf die Schicht (15) oder auf eine zweite Fläche der mindestens einen Reihe (40).

**3.** Verfahren zur Herstellung kombinierter Solarplatten (10) nach Anspruch 1 oder 2, **dadurch gekennzeichnet, dass** das Einbringen des Harzes (58) Folgendes umfasst:

    - Partielle Abdichtung des Moduls (18), wobei mindestens eine Seite der Vielzahl von Seiten mit einer nicht abgedichteten Zone (57) verbleibt;
    - Positionierung des Moduls (18) in eine im Wesentlichen vertikalen Lage, so dass die mindestens eine Zone (57) in einer oberen Position angeordnet ist;
    - Das Modul (18) mittels der Zone (57) mit einem bestimmten Vakuumlevel zu versehen und
    - Einbringen des Harzes (58) in das Modul (18), wobei der Vakuumlevel progressiv ansteigt.

**4.** Verfahren zur Herstellung kombinierter Solarplatten (10) nach Anspruch 3, **dadurch gekennzeichnet, dass** das Einbringen des Harzes (58) folgende weitere Schritte umfasst:

- Positionierung des Moduls (18) in eine im Wesentlichen horizontale Lage;
- Vollständige Abdichtung des Moduls (18).

**5.** Verfahren zur Herstellung kombinierter Solarplatten (10) nach einem der Ansprüche 1 bis 4, **dadurch gekennzeichnet, dass** die Herstellung der thermischen Platte (12) folgende Verfahrensschritte umfasst:

- Aufbringen mindestens einer Schicht (24) kontaktierendes elektrischens Isoliermaterials auf die mindestens eine ebene Fläche (26b).

**6.** Verfahren zur Herstellung kombinierter Solarplatten (10) nach einem der Ansprüche 1 bis 5, **dadurch gekennzeichnet, dass** der Verfahrensschritt zur Herstellung der fotovoltaischen Platte (11) auch die Bildung mindestens einer Reihe (40) von Zellen (41) umfasst, die erste Kontakte (42a) und zweite Kontakte (42b) von entgegengesetzter Polarität aufweisen und eine festgelegte Querschnittsgröße aufweisen;
die Herstellung dieser Reihe weist folgende Schritte auf

- Anbringung erster Rheophore (43a) an den ersten Kontakten (42a) mit einem Querschnitt, der größer ist als der Querschnitt der ersten Kontakte (42a);
- Anbringung zweiter Rheophore (43b) an den zweiten Kontakten (42b) mit einem Querschnitt, der größer ist als der Querschnitt der zweiten Kontakte (42b);
- Verbindung der ersten Rheophore (43a) einer ersten Zelle (41) mit den zweiten Rheophoren (43b) einer zweiten Zelle (41) und Wiederholung des Verbindungsvorgangs an den in der Reihe vorhandenen Zellen, um eine Serienschaltung der Zellen (41) zu erreichen.

**7.** Kombinierte Solarplatte (10) mit

- einer thermischen Platte (12) mit mindestens einer ebenen Fläche (26b);
- einem zur Kombination mit der ebenen Fläche (26b) der thermischen Platte (12) geeigneten fotovoltaischen Platte (11), die mindestens eine Reihe (40) mit einer Vielzahl miteinander verbundener fotovoltaischer Zellen (41) sowie eine transparente Schicht (15) aufweist;
- eine Anzahl von Klebepunkten (54, 55) zwischen der ebenen Fläche (26b) und der mindestens einen Reihe (40) beziehungsweise der mindestens einen Reihe (40) und der Schicht (15), **gekennzeichnet durch**:

- ein transparentes Harz (58) zwischen der ebenen Fläche (26b) und der mindestens einen Reihe (40) sowie zwischen der mindestens einen Reihe (40) und der Schicht (15).

**8.** Solarplatte (10) nach Anspruch 7, **dadurch gekennzeichnet, dass** die Klebepunkte aus einem Material oder einer Kombination von Materialien hergestellt werden, die aus folgenden Werkstoffgruppen ausgewählt werden:

- Silikon mit UV-Katalysator;
- Polyurethan.

**9.** Solarplatte (10) nach Anspruch 7 oder 8, **dadurch gekennzeichnet, dass** das Harz eine Modifikation eines Materials oder einer Kombination von Materialien ist, die aus folgenden Werkstoffgruppen ausgewählt wurden:

- ausgehärtetes Harz Typ CE9500;
- ausgehärtetes Harz Typ CE100-7 A.E.;
- ausgehärtetes Harz Typ NT620.

**10.** Solarplatte (10) nach einem der Ansprüche 7 bis 9, **gekennzeichnet durch**
mindestens eine Schicht (24) aus elektrischem Isoliermaterial, die mit der mindestens einen ebenen Fläche (26b) der thermischen Platte (12) in Kontakt ist.

**11.** Solarplatte (10) nach einem der Ansprüche 7 bis 10, **dadurch gekennzeichnet, dass** die Zellen (41) der Vielzahl von Zellen erste Kontakte (42a) und zweite Kontakte (42b) von entgegengesetzter Polarität mit einer festgelegten Querschnittsgröße aufweisen und dass an den ersten Kontakten (42a) erste Rheophoren (43a) befestigt sind, deren Querschnitt größer ist als der Querschnitt der ersten Kontakte (42a), und dass an den zweiten Kontakten (42b) zweite Rheophoren (43b) befestigt sind, deren Querschnitt größer ist als der Querschnitt der zweiten Kontakte (42b).

**12.** Solarplatte (10) nach Anspruch 11, **dadurch gekennzeichnet, dass** die zweiten Rheophoren durch ein dünne Metallplatte gebildet sind, die an die zweiten Kontakte (42b) angeschweißt ist.

**Revendications**

**1.** Procédé de fabrication de panneaux solaires combinés (10) du type photovoltaïque et thermique, comprenant les étapes consistant à

- construire un panneau thermique (12) comportant au moins une face plate (26b) ;

- construire un panneau photovoltaïque (11) conçu pour être combiné avec ledit panneau thermique (12) par l'intermédiaire de ladite face plate (26b) et comprenant au moins une chaîne (40) de cellules photovoltaïques (41) et une feuille transparente (15) ;

**caractérisé en ce que** l'étape de construction panneau photovoltaïque (11) comprend les étapes consistant à

- appliquer un certain nombre de points de colle (54, 55) respectivement entre ladite face plate (26b) et ladite au moins une chaîne (40) et entre ladite au moins une chaîne (40) et ladite feuille (15), de façon à former un module combiné (18) doté de plusieurs côtés périphériques ;
- introduire une résine transparente (58) entre ladite face plate (26b) et ladite au moins une chaîne (40) et entre ladite au moins une chaîne (40) et ladite feuille (15).

2. Procédé de fabrication de panneaux solaires combinés (10) selon la revendication 1, **caractérisé en ce que** l'étape d'application des points de colle (54, 55) consiste à

- appliquer un premier ensemble de points de colle (54) sur ladite face plate (26b) ou sur une première face de ladite au moins une chaîne (40) ;
- appliquer un second ensemble de points de colle (54) sur ladite feuille (15) ou sur une seconde face de ladite au moins une chaîne (40).

3. Procédé de fabrication de panneaux solaires combinés (10) selon la revendication 1 ou 2, **caractérisé en ce que** ladite étape d'introduction de la résine (58) consiste à

- sceller partiellement ledit module (18) en laissant au moins un côté de desdits plusieurs côtés doté d'une zone non scellée (57) ;
- positionner le module (18) dans une position sensiblement verticale de sorte que ladite au moins une zone (57) se trouve dans une position haute ;
- appliquer audit module (18) un niveau de vide donné par ladite zone (57) ; et
- introduire ladite résine (58) dans ledit module (18) en augmentant progressivement le niveau du vide appliqué.

4. Procédé de fabrication de panneaux solaires combinés (10) selon la revendication 3, **caractérisé en ce que** l'étape d'introduction de la résine (58) comprend en outre les étapes consistant à

- positionner le module (18) dans une position sensiblement horizontale ;
- sceller complètement ledit module (18).

5. Procédé de fabrication de panneaux solaires combinés (10) selon l'une quelconque des revendications 1 à 4, **caractérisé en ce que** l'étape de fabrication du panneau thermique (12) comprend l'étape consistant à

- appliquer au moins une couche (24) de matériau électriquement isolant en contact avec ladite au moins une face plate (26b).

6. Procédé de fabrication de panneaux solaires combinés (10) selon l'une quelconque des revendications 1 à 5, **caractérisé en ce que** l'étape de fabrication du panneau photovoltaïque (11) consiste également à construire au moins une chaîne (40) de cellules (41), lesdites cellules comprenant des premiers contacts (42a) et des seconds contacts (42b) de polarité opposée et ayant une dimension de section transversale prédéterminée ; la construction de ladite chaîne comprenant les étapes consistant à

- appliquer auxdits premiers contacts (42a) des premiers rhéophores (43a) ayant une dimension de section transversale supérieure à la dimension de la section transversale desdits premiers contacts (42a) ;
- appliquer auxdits seconds contacts (42b) des seconds rhéophores (43b) ayant une dimension de section transversale supérieure à la dimension de la section transversale desdits seconds contacts (42b) ;
- connecter les premiers rhéophores (43a) d'une première cellule (41) aux seconds rhéophores (43b) d'une seconde cellule (41) et répéter l'opération de connexion des cellules présentes dans la chaîne de façon à réaliser une connexion en série des cellules (41).

7. Panneau solaire combiné (10) comprenant

- un panneau thermique (12) comportant au moins une face plate (26b) ;
- un panneau photovoltaïque (11) conçu pour être combiné avec ledit panneau thermique (12) par l'intermédiaire de ladite face plate (26b) et comprenant au moins une chaîne (40) comprenant une pluralité de cellules photovoltaïques (41) connectées les unes aux autres et une feuille transparente (15) ;
- un certain nombre de points de colle (54, 55) respectivement entre ladite face plate (26b) et ladite au moins une chaîne (40) et entre ladite au moins une chaîne (40) et ladite feuille (15) ;

**caractérisé en ce qu'**il comprend

- une résine transparente (58) entre ladite face plate (26b) et ladite au moins une chaîne (40) et entre ladite au moins une chaîne (40) et ladite feuille (15).

8. Panneau solaire (10) selon la revendication 7, **caractérisé en ce que** lesdits points de colle sont constitués d'un matériau ou d'une combinaison de matériaux sélectionnés à partir du groupe constitué :

- de silicone à catalyseur UV ;
- de polyuréthane.

9. Panneau solaire (10) selon la revendication 7 ou 8, **caractérisé en ce que** ladite résine est constituée d'un matériau ou d'une combinaison de matériaux sélectionnés à partir du groupe constitué :

- d'une résine polymérisée de type CE9500 ;
- d'une résine polymérisée de type CE100-7 A.E. ;
- d'une résine polymérisée de type NT620.

10. Panneau solaire (10) selon l'une quelconque des revendications 7 à 9, **caractérisé en ce qu'**il comprend
au moins une couche (24) de matériau électriquement isolant en contact avec ladite au moins une face plate (26b) dudit panneau thermique (12).

11. Panneau solaire (10) selon l'une quelconque des revendications 7 à 10, **caractérisé en ce que** lesdites cellules (41) de ladite pluralité de cellules comprennent des premiers contacts (42a) et des seconds contacts (42b) de polarité opposée ayant une section transversale de dimension prédéterminée et **en ce que** des premiers rhéophores (43a) sont fixés auxdits premiers contacts (42a), lesquels rhéophores ont une dimension de section transversale supérieure à la dimension de la section transversale desdits premiers contacts (42a), et **en ce que** des seconds rhéophores (43b) sont fixés auxdits seconds contacts, lesquels rhéophores ont une dimension de section transversale supérieure à la dimension de la section transversale desdits seconds contacts (42b).

12. Panneau solaire (10) selon la revendication 11, **caractérisé en ce que** lesdits seconds rhéophores sont réalisés au moyen d'un métal en feuille mince soudé auxdits seconds contacts (42b).

Fig. 1

Fig. 6

Fig. 2

Fig. 3

Fig. 4a

Fig. 4b

Fig. 5a

Fig. 5b

**EP 2 074 356 B1**

**REFERENCES CITED IN THE DESCRIPTION**

**Patent documents cited in the description**

- US 20040025931 A
- WO 9910934 A